# EUROPEAN PATENT APPLICATION

(11) **EP 4 737 914 A1**
(43) Date of publication of application: **06.05.2026**
(21) Application number: 24831922.0
(22) Date of filing: 24.06.2024
(51) Int. Cl.: G01R 11/02, G01R 19/00, H03D 1/04, H03D 1/18

(54) **POWER DETECTOR**

(30) Priority: 29.06.2023 JP 2023106853
(71) Applicant: Fujikura Ltd., Tokyo 135-8512 (JP)
(72) Inventor: KAMIDAKI Chihiro, Sakura-shi, Chiba 285-8550 (JP)
(74) Representative: Lavoix
(86) International application number: PCT/JP2024/022905
(87) International publication number: WO 2025/005062

(57) **Abstract**

A power detector according to an aspect of the present invention includes a main current mirror circuit that outputs a detection current indicating power of a high-frequency signal from an output end, a reference current mirror circuit that is the same as the main current mirror circuit, a current mirror circuit for connection that has an input end connected to an output end of the reference current mirror circuit and has an output end connected to the main output end to output a reference current, and a differential amplifier that generates a power detection signal based on an input voltage of an initial-stage transistor, to which the high-frequency signal is input, in the main current mirror circuit and an input bias voltage of a corresponding transistor, which corresponds to the initial-stage transistor, in the reference current mirror circuit, in which the input bias voltage of the initial-stage transistor in the main current mirror circuit is set based on a first reference current, and the input bias voltage of the corresponding transistor in the reference current mirror circuit is set based on a total current of a deviation current between the detection current and the reference current and a second reference current.

## Description

### TECHNICAL FIELD

The present invention relates to a power detector.

Priority is claimed on Japanese Patent Application No. 2023-106853, filed June 29, 2023, the content of which is incorporated herein by reference.

### BACKGROUND ART

Patent Document 1 discloses a power detector that detects high-frequency power. As shown in FIG. 2 and the like of Patent Document 1, the power detector includes an original rectifier that performs a half-wave rectification on a high-frequency signal, a replica rectifier that has the same circuit characteristics as the original rectifier, a low-pass filter that smooths an output of the original rectifier, and a differential amplifier that is configured to differentially amplify an output of the low-pass filter and an output of the replica rectifier. Such a power detector differentially amplifies the output of the low-pass filter and the output of the replica rectifier in the differential amplifier to reduce a variation in a detection amount due to a manufacturing variation of the original rectifier or a temperature fluctuation.

### Citation List

### Patent Document

Patent Document 1: United States Patent No. 6791312

### SUMMARY OF INVENTION

### Technical Problem

However, in the power detector of Patent Document 1, there is a problem that the power detector is easily affected by external noise since an output voltage of the original rectifier and an output voltage of the replica rectifier are differentially amplified using the differential amplifier. That is, in the existing power detector, the detection amount fluctuates due to the external noise, which makes it difficult to obtain an accurate detection amount. For example, since power detection of a high-frequency signal in a gigahertz band is easily affected by the external noise unlike the power detection of a low-frequency signal, suppression of the influence of the external noise in the power detector is an extremely important technical problem.

The present invention has been made in view of the above circumstances, and an object of the present invention is to provide a power detector capable of suppressing an influence of external noise.

### Solution to problem

In order to achieve the aforementioned objects, a first aspect of the present invention is a power detector including a main current mirror circuit that is configured to rectify a high-frequency signal to output, from a main output end, a detection current indicating power of the high-frequency signal, a reference current mirror circuit that has the same circuit configuration and circuit performance as the main current mirror circuit, a current mirror circuit for connection that has an input end connected to a reference output end of the reference current mirror circuit and has a connection output end connected to the main output end to output a reference current, and a differential amplifier that is configured to differentially amplify an input voltage of an initial-stage transistor, to which the high-frequency signal is input, in the main current mirror circuit and an input bias voltage of a corresponding transistor, which corresponds to the initial-stage transistor, in the reference current mirror circuit to generate a power detection signal, in which the input bias voltage of the initial-stage transistor in the main current mirror circuit is set based on a first reference current, the input bias voltage of the corresponding transistor in the reference current mirror circuit is set based on a total current of a deviation current between the detection current and the reference current and a second reference current, and the first reference current and the second reference current are the same.

A second aspect of the present invention is the power detector according to the first aspect, in which the main current mirror circuit includes a first main current mirror circuit that is configured of n-type transistors and includes the initial-stage transistor, and a second main current mirror circuit that is connected to an output end of the first main current mirror circuit and is configured of p-type transistors, and the reference current mirror circuit includes a first reference current mirror circuit that is configured of n-type transistors and includes the corresponding transistor, and a second reference current mirror circuit that is connected to an output end of the first reference current mirror circuit and is configured of p-type transistors.

A third aspect of the present invention is the power detector according to the second aspect, in which mirror ratios of the second main current mirror circuit and the second reference current mirror circuit are set to values larger than 1.

A fourth aspect of the present invention is the power detector according to the second or third aspect, in which mirror ratios of the first main current mirror circuit and the first reference current mirror circuit are set to 1 or values smaller than 1.

A fifth aspect of the present invention is the power detector according to any one of the second to fourth aspects, in which the n-type transistor is an n-type metal-oxide-semiconductor field effect transistor (MOSFET), and the p-type transistor is a p-type metal-oxide-semiconductor field effect transistor (MOSFET).

A sixth aspect of the present invention is the power detector according to any one of the first to fifth aspects, in which the differential amplifier is an instrumentation amplifier.

A seventh aspect of the present invention is the power detector according to any one of the first to sixth aspects, the power detector further including a voltage-to-current conversion circuit that is configured to convert an output voltage of the differential amplifier into a current, and a current-to-voltage conversion circuit that is configured to convert an output current of the voltage-to-current conversion circuit into a voltage.

An eighth aspect of the present invention is the power detector according to any one of the first to seventh aspects, the power detector further including a plurality of power detection units each of which includes a main circuit configured of a main rectifier, a first resistor circuit, and a second resistor circuit, a reference circuit configured of a replica rectifier, the first resistor circuit, and the second resistor circuit, and the differential amplifier, in which the power detection signals of the plurality of power detection units are averaged to detect the power of the high-frequency signal.

A ninth aspect of the present invention is the power detector according to any one of the first to seventh aspects, the power detector further including a plurality of power detection units each of which includes a main circuit configured of a main rectifier, a first resistor circuit, and a second resistor circuit, a reference circuit configured of a replica rectifier, the first resistor circuit, and the second resistor circuit, the differential amplifier, and an opening/closing switch, in which each of the power detection signals of the plurality of power detection units is sequentially switched by the opening/closing switch and is transmitted to an output circuit to detect the power of the high-frequency signal input to and output from each of the plurality of power detection units.

### Advantageous Effects of Invention

According to the present invention, it is possible to provide the power detector capable of suppressing the influence of the external noise.

### BRIEF DESCRIPTION OF DRAWINGS

[FIG. 1] A circuit diagram showing an overall configuration of a power detector according to a first embodiment of the present invention.
[FIG. 2] A schematic diagram showing a relationship between a main rectifier, a replica rectifier, a first resistor circuit, and a second resistor circuit in the first embodiment of the present invention.
[FIG. 3] A circuit diagram showing a detailed configuration of the main rectifier of the power detector according to the first embodiment of the present invention.
[FIG. 4] A circuit diagram showing a detailed configuration of the replica rectifier of the power detector according to the first embodiment of the present invention.
[FIG. 5A] A circuit diagram showing detailed configurations of the first resistor circuit and the second resistor circuit of the power detector according to the first embodiment of the present invention.
[FIG. 5B] A circuit diagram showing a detailed configuration of the differential amplifier of the power detector according to the first embodiment of the present invention.
[FIG. 6A] A circuit diagram showing a detailed configuration of a voltage-to-current conversion circuit of the power detector according to the first embodiment of the present invention.
[FIG. 6B] A circuit diagram showing a detailed configuration of an output circuit of the power detector according to the first embodiment of the present invention.
[FIG. 7] A circuit diagram showing an overall configuration of a power detector according to a second embodiment of the present invention.

### DESCRIPTION OF EMBODIMENTS

### (First Embodiment)

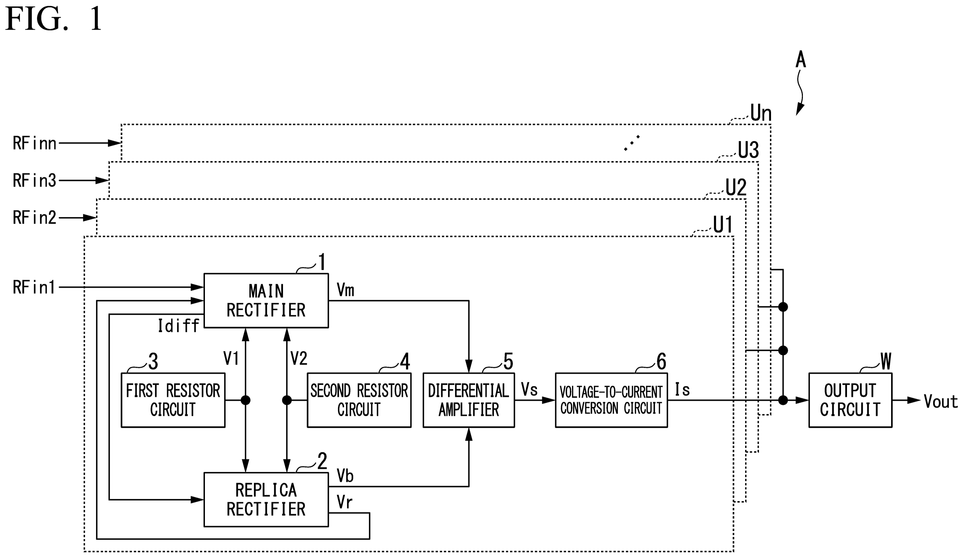

Hereinafter, a first embodiment of the present invention will be described with reference to FIGS. 1 to 6B. A power detector A according to the present embodiment includes n (n: natural number of two or more) power detection units U1 to Un and a single output circuit W, as shown in FIG. 1. That is, the power detector A includes the plurality of power detection units U1 to Un.

High-frequency signals RFin1 to RFinn having the same subscript are each input to the n power detection units U1 to Un, as illustrated in the drawing. For example, the high-frequency signal RFin1 is input to the power detection unit U1, and the high-frequency signal RFin2 is input to the power detection unit U2. In the following, the n high-frequency signals RFin1 to RFinn are collectively referred to as the high-frequency signal RFin.

In the n power detection units U1 to Un, one of such n high-frequency signals RFin1 to RFinn is received as an input, and a detection current Is indicating power of each of the n high-frequency signals RFin1 to RFinn is output to the output circuit W. For example, the power detection unit U1 outputs a detection current Is1 indicating the power of the high-frequency signal RFin1 to the output circuit W, and the power detection unit U2 outputs a detection current Is2 indicating the power of the high-frequency signal RFin2 to the output circuit W.

All of such n power detection units U1 to Un have the same circuit configuration. Further, each of the n power detection units U1 to Un specifically includes a main rectifier 1, a replica rectifier 2, a first resistor circuit 3, a second resistor circuit 4, a differential amplifier 5, and a voltage-to-current conversion circuit 6.

The main rectifier 1, the first resistor circuit 3, and the second resistor circuit 4, among such circuits, configure a main circuit in the present invention. Further, the replica rectifier 2, the first resistor circuit 3, and the second resistor circuit 4 configure a reference circuit in the present invention. Furthermore, the differential amplifier 5 corresponds to a differential amplifier in the present invention.

Although details will be described below, the main rectifier 1 receives the high-frequency signal RFin and a reference voltage Vr as inputs, outputs a detection current by performing a half-wave rectification and smoothing on the high-frequency signal RFin, and outputs a deviation current Idiff between the detection current and a reference current based on the reference voltage Vr input from the replica rectifier 2 to the replica rectifier 2.

Further, the main rectifier 1 outputs, to the differential amplifier 5, a gate voltage (input voltage) of an n-type transistor (initial-stage transistor) to which the high-frequency signal RFin is input, as a main operation voltage Vm. The main operation voltage Vm is a mixed voltage of an input bias voltage (direct-current voltage) set based on a first reference current Iref and the high-frequency signal RFin (alternating current).

A circuit configuration and circuit performance of the replica rectifier 2 are configured to be the same as those of the main rectifier 1. The replica rectifier 2 generates the reference voltage Vr based on the input bias voltage set based on a total current of a second reference current Iref, which is set to be the same as the first reference current Iref, and the deviation current Idiff. The replica rectifier 2 outputs the reference voltage Vr to the main rectifier 1.

Further, the replica rectifier 2 outputs, to the differential amplifier 5, a gate voltage (input bias voltage) of an n-type transistor (corresponding transistor), which corresponds to the n-type transistor of the main rectifier 1, as a reference operation voltage Vb. Since the high-frequency signal RFin is not input to the replica rectifier 2, the reference operation voltage Vb is a direct-current voltage.

The first resistor circuit 3 is a resistor voltage-dividing circuit that generates a first bias voltage V1 by resistor voltage division. The second resistor circuit 4 is a resistor voltage-dividing circuit that generates a second bias voltage V2, which is different from the first bias voltage V1, by the resistor voltage division. The first resistor circuit 3 and the second resistor circuit 4, that is, the function of generating the first bias voltage V1 and the second bias voltage V2 may be provided within the main rectifier 1 and the replica rectifier 2, instead of being provided as separate circuits from the main rectifier 1 and the replica rectifier 2.

The first resistor circuit 3 and the second resistor circuit 4 are auxiliary circuits that supply the first bias voltage V1 and the second bias voltage V2 to the main rectifier 1 and the replica rectifier 2 as described above. That is, the main rectifier 1 and the replica rectifier 2 receive the first bias voltage V1 and the second bias voltage V2 from the first resistor circuit 3 and the second resistor circuit 4 as inputs to exhibit a desired circuit function.

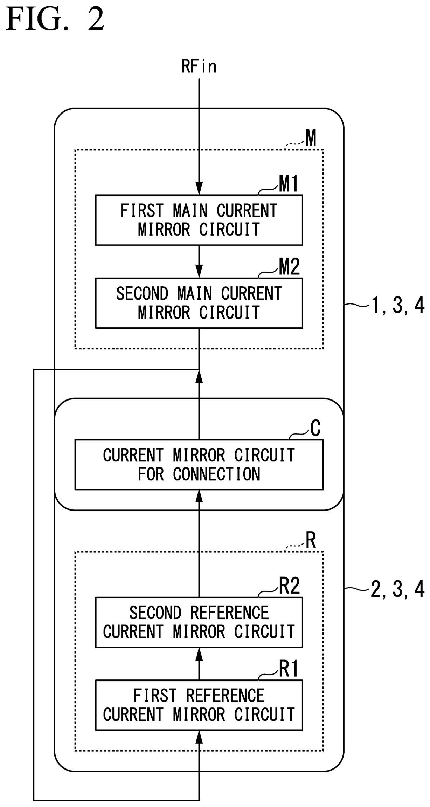

As a functional configuration, the main rectifier 1, the replica rectifier 2, the first resistor circuit 3, and the second resistor circuit 4 have a relationship shown in FIG. 2. That is, the main rectifier 1, the first resistor circuit 3, and the second resistor circuit 4 configure a first main current mirror circuit M1 and a second main current mirror circuit M2. Further, the first main current mirror circuit M1 and the second main current mirror circuit M2 configure a main current mirror circuit M.

The replica rectifier 2, the first resistor circuit 3, and the second resistor circuit 4 configure a first reference current mirror circuit R1 and a second reference current mirror circuit R2. Further, the first reference current mirror circuit R1 and the second reference current mirror circuit R2 configure a reference current mirror circuit R.

Further, the main rectifier 1, the replica rectifier 2, the first resistor circuit 3, and the second resistor circuit 4 configure a current mirror circuit for connection C. That is, the current mirror circuit for connection C is a current mirror circuit that straddles the main rectifier 1 and the replica rectifier 2. The high-frequency signal RFin is input to an input end of the first main current mirror circuit M1.

An output end of the first main current mirror circuit M1 is connected to an input end of the second main current mirror circuit M2. An output end of the second main current mirror circuit M2 (main output end) is connected to an output end of the current mirror circuit for connection C (connection output end), and is also connected to an input end of the first reference current mirror circuit R1. An output end of the first reference current mirror circuit R1 is connected to an input end of the second reference current mirror circuit R2. Further, an output end of the second reference current mirror circuit R2 (reference output end) is connected to an input end of the current mirror circuit for connection C.

The differential amplifier 5 receives the main operation voltage Vm and the reference operation voltage Vb as inputs, and differentially amplifies the main operation voltage Vm and the reference operation voltage Vb to generate a difference voltage Vs. The difference voltage Vs is a signal indicating the power of the high-frequency signal RFin. The differential amplifier 5 outputs such a difference voltage Vs to the voltage-to-current conversion circuit 6. An instrumentation amplifier capable of variably setting an amplification factor may be employed as the differential amplifier 5.

The voltage-to-current conversion circuit 6 converts the difference voltage Vs, which is input from the differential amplifier 5, into a current to generate the difference current Is. The difference current Is is an output in each of the n power detection units U1 to Un. Output ends of the voltage-to-current conversion circuits 6 in the respective n power detection units U1 to Un are connected to each other as illustrated in the drawing, and are connected to an input end of the output circuit W.

The output circuit W is a current-to-voltage conversion circuit with the difference current Is, which is input from each of the n power detection units U1 to Un, as an input signal. That is, the output circuit W averages the n difference currents Is, converts the averaged current into an output voltage Vout, and outputs the output voltage Vout to the outside. Such a power detector A is a power detection circuit that is made redundant by including the n power detection units U1 to Un.

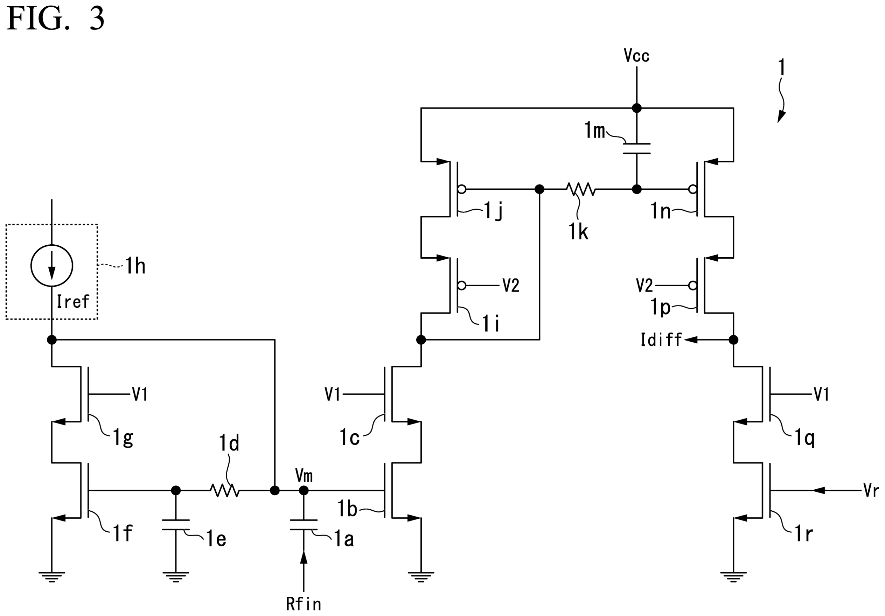

Each of the n power detection units U1 to Un and the output circuit W will be further described. The main rectifier 1 includes a coupling capacitor 1a, a first transistor 1b, a second transistor 1c, a first resistor 1d, a first capacitor 1e, a third transistor 1f, a fourth transistor 1g, a constant current source 1h, a fifth transistor 1i, a sixth transistor 1j, a second resistor 1k, a second capacitor 1m, a seventh transistor 1n, an eighth transistor 1p, a ninth transistor 1q, and a tenth transistor 1r, as shown in FIG. 3.

The coupling capacitor 1a has a predetermined capacitance. The high-frequency signal RFin is input to one end of the coupling capacitor 1a, and a gate terminal of the first transistor 1b, one end of the first resistor 1d, an output end of the constant current source 1h, and a drain terminal of the fourth transistor 1g are connected to the other end of the coupling capacitor 1a. The coupling capacitor 1a is for removing a direct-current signal component included in the high-frequency signal RFin to hold a direct-current component of the voltage Vm at the input bias voltage set based on the first reference current Iref. That is, the coupling capacitor 1a applies only an alternating-current component of the high-frequency signal RFin to the gate terminal of the first transistor 1b.

The first transistor 1b is an n-type transistor. As illustrated in the drawing, the gate terminal of the first transistor 1b is connected to the other end of the coupling capacitor 1a, one end of the first resistor 1d, the output end of the constant current source 1h, and the drain terminal of the fourth transistor 1g, and a drain terminal of the first transistor 1b is connected to a source terminal of the second transistor 1c, and the source terminal of the first transistor 1b is grounded. The first transistor 1b performs the half-wave rectification on the high-frequency signal RFin with the bias voltage (input bias voltage) of the gate terminal as a rectification threshold value, and outputs the obtained half-wave rectified signal to the source terminal of the second transistor 1c. Such a first transistor 1b is the initial-stage transistor in the present invention.

The second transistor 1c is an n-type transistor. The second transistor 1c is a cascode transistor that is connected in cascode with the first transistor 1b (initial-stage transistor), as illustrated in the drawing. That is, the source terminal of the second transistor 1c is connected to the drain terminal of the first transistor 1b. Further, a gate terminal of the second transistor 1c is connected to an output end of the first resistor circuit 3, and the first bias voltage V1 is applied to the gate terminal thereof. Furthermore, a drain terminal of the second transistor 1c is connected to a drain terminal of the fifth transistor 1i, a gate terminal of the sixth transistor 1j, and one end of the second resistor 1k.

The first resistor 1d has a predetermined resistance value. One end of the first resistor 1d is connected to the other end of the coupling capacitor 1a, the gate terminal of the first transistor 1b, the output end of the constant current source 1h, and the drain terminal of the fourth transistor 1g, and the other end of the first resistor 1d is connected to one end of the first capacitor 1e and a gate terminal of the third transistor 1f. The first resistor 1d configures, together with the first capacitor 1e, a low-pass filter having a predetermined time constant, and prevents the alternating-current component of the high-frequency signal RFin from being input to the gate terminal of the third transistor 1f.

The first capacitor 1e has a predetermined capacitance. One end of the first capacitor 1e is connected to the other end of the first resistor 1d and the gate terminal of the third transistor 1f, and the other end of the first capacitor 1e is grounded. The first capacitor 1e configures, together with the first resistor 1d, a low-pass filter having a predetermined time constant, and prevents the alternating-current component of the high-frequency signal RFin from being input to the gate terminal of the third transistor 1f. That is, only the direct-current component of the main output voltage Vm is input to the gate terminal of the third transistor 1f.

The third transistor 1f is an n-type transistor. As illustrated in the drawing, a gate terminal of the third transistor 1f is connected to the other end of the first resistor 1d and one end of the first capacitor 1e, and a drain terminal of the third transistor 1f is connected to a source terminal of the fourth transistor 1g, and the source terminal of the third transistor 1f is grounded.

The fourth transistor 1g is an n-type transistor. The fourth transistor 1g is a cascode transistor that is connected in cascode with the third transistor 1f, as illustrated in the drawing. That is, the source terminal of the fourth transistor 1g is connected to the drain terminal of the third transistor 1f. Further, a gate terminal of the fourth transistor 1g is connected to the output end of the first resistor circuit 3, and the first bias voltage V1 is applied to the gate terminal thereof. Further, the drain terminal of the fourth transistor 1g is connected to the output end of the constant current source 1h, the other end of the coupling capacitor 1a, the gate terminal of the first transistor 1b, and one end of the first resistor 1d.

The output end of the constant current source 1h is connected to the other end of the coupling capacitor 1a, the gate terminal of the first transistor 1b, one end of the first resistor 1d, and the drain terminal of the fourth transistor 1g. The first reference current Iref (direct current) is output from the output end of the constant current source 1h.

A gate voltage in the first transistor 1b is the main operation voltage Vm as illustrated in the drawing. The main operation voltage Vm is a mixed voltage obtained by superimposition of the alternating-current component of the high-frequency signal RFin on the input bias voltage (direct-current voltage), which is set by the first reference current Iref, the first resistor 1d, the first capacitor 1e, the third transistor 1f, and the fourth transistor 1g.

A gate bias voltage at such a main operation voltage Vm is a threshold value in a case where the first transistor 1b performs the half-wave rectification on the high-frequency signal RFin. That is, the gate bias voltage of the first transistor 1b sets an operating point in the half-wave rectification of the high-frequency signal RFin. The high-frequency signal RFin subjected to the half-wave rectification with the gate bias voltage as the operating point, that is, the half-wave rectified signal is output to the drain terminal of the second transistor 1c that is connected in cascode with the first transistor 1b.

The fifth transistor 1i is a p-type transistor. The fifth transistor 1i is a cascode transistor that is connected in cascode with the sixth transistor 1j, as illustrated in the drawing. That is, a source terminal of the fifth transistor 1i is connected to a drain terminal of the sixth transistor 1j. The half-wave rectified signal is input to the fifth transistor 1i from the drain terminal of the second transistor 1c.

Further, a gate terminal of the fifth transistor 1i is connected to an output end of the second resistor circuit 4, and the second bias voltage V2 is applied to the gate terminal thereof. Furthermore, the drain terminal of the fifth transistor 1i is connected to the drain terminal of the second transistor 1c, the gate terminal of the sixth transistor 1j, and one end of the second resistor 1k.

The sixth transistor 1j is a p-type transistor. As illustrated in the drawing, a gate terminal of the sixth transistor 1j is connected to the drain terminal of the second transistor 1c, the drain terminal of the fifth transistor 1i, and one end of the second resistor 1k, the drain terminal of the sixth transistor 1j is connected to the source terminal of the fifth transistor 1i, and a source terminal of the sixth transistor 1j is connected to a power supply Vcc.

One end of the second resistor 1k is connected to the drain terminal of the second transistor 1c, the drain terminal of the fifth transistor 1i, and the gate terminal of the sixth transistor 1j, and the other end of the second resistor 1k is connected to one end of the second capacitor 1m and a gate terminal of the seventh transistor 1n. The second resistor 1k configures, together with the second capacitor 1m, a low-pass filter having a predetermined time constant, and prevents the alternating-current component of the half-wave rectified signal, which is input from the drain terminal of the second transistor 1c, from being input to the gate terminal of the seventh transistor 1n.

The second capacitor 1m has a predetermined capacitance. One end of the second capacitor 1m is connected to the other end of the second resistor 1k and the gate terminal of the seventh transistor 1n, and the other end of the second capacitor 1m is connected to the power supply Vcc, the source terminal of the sixth transistor 1j, and a source terminal of the seventh transistor 1n. The second capacitor 1m configures, together with the second resistor 1k, a low-pass filter having a predetermined time constant, and smooths the half-wave rectified signal to input the smoothed half-wave rectified signal to the gate terminal of the seventh transistor 1n. That is, the direct-current voltage obtained by the smoothing of the half-wave rectified signal is input to the gate terminal of the seventh transistor 1n. The direct-current voltage is a detection voltage indicating the power of the high-frequency signal RFin.

The seventh transistor 1n is a p-type transistor. As illustrated in the drawing, the gate terminal of the seventh transistor 1n is connected to the other end of the second resistor 1k and one end of the second capacitor 1m, a drain terminal of the seventh transistor 1n is connected to a source terminal of the eighth transistor 1p, and the source terminal of the seventh transistor 1n is connected to the power supply Vcc, the other end of the second capacitor 1m, and the source terminal of the sixth transistor 1j. The seventh transistor 1n amplifies the detection voltage input to the gate terminal of the seventh transistor 1n, and outputs the amplified detection voltage to the source terminal of the eighth transistor 1p from the drain terminal of the seventh transistor 1n.

The eighth transistor 1p is a p-type transistor. The eighth transistor 1p is a cascode transistor that is connected in cascode with the seventh transistor 1n, as illustrated in the drawing. That is, the source terminal of the eighth transistor 1p is connected to the drain terminal of the seventh transistor 1n. The detection voltage is input to the eighth transistor 1p from the drain terminal of the seventh transistor 1n.

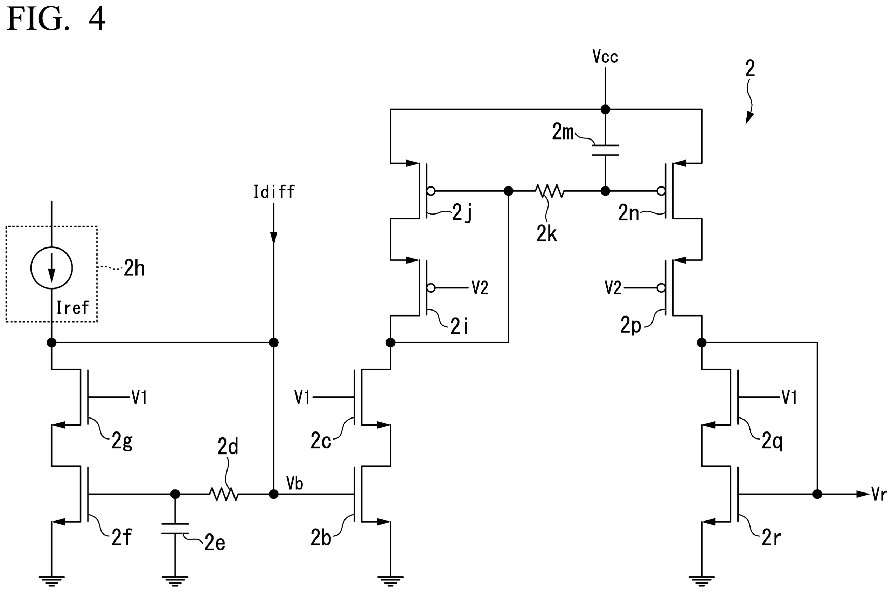

Further, a gate terminal of the eighth transistor 1p is connected to the output end of the second resistor circuit 4, and the second bias voltage V2 is applied to the gate terminal thereof. Further, a drain terminal of the eighth transistor 1p is connected to a drain terminal of the ninth transistor 1q, and as shown in FIG. 4, is connected to a gate terminal of the first transistor 2b, a drain terminal of a fourth transistor 2g, one end of a first resistor 2d, and an output end of a constant current source 2h in the replica rectifier 2. That is, the drain terminal of the eighth transistor 1p outputs the deviation current Idiff to the replica rectifier 2.

The ninth transistor 1q is an n-type transistor. The ninth transistor 1q is a cascode transistor that is connected in cascode with the tenth transistor 1r, as illustrated in the drawing. That is, a source terminal of the ninth transistor 1q is connected to a drain terminal of the tenth transistor 1r. Further, a gate terminal of the ninth transistor 1q is connected to the output end of the first resistor circuit 3, and the first bias voltage V1 is applied to the gate terminal thereof. Furthermore, the drain terminal of the ninth transistor 1q is connected to the drain terminal of the eighth transistor 1p.

The tenth transistor 1r is an n-type transistor. As illustrated in the drawing, the reference voltage Vr is input to a gate terminal of the tenth transistor 1r from the replica rectifier 2, the drain terminal of the tenth transistor 1r is connected to the source terminal of the ninth transistor 1q, and a source terminal of the tenth transistor 1r is grounded. That is, a gate terminal of the tenth transistor 1r is connected to a drain terminal of an eighth transistor 2p, a drain terminal of a ninth transistor 2q, and a gate terminal of a tenth transistor 2r in the replica rectifier 2 as shown in FIG. 4.

The ninth transistor 1q and the tenth transistor 1r, which are connected in cascode in this manner, amplify the reference voltage Vr input to the gate terminal of the tenth transistor 1r, and output the amplified reference voltage Vr to the drain terminal of the tenth transistor 1r. Since the drain terminal of the tenth transistor 1r is connected to the source terminal of the ninth transistor 1q, the deviation current Idiff, which is a difference between the detection current based on the half-wave rectified signal of the high-frequency signal RFin and the reference current based on the reference voltage Vr, is output to the replica rectifier 2 from the ninth transistor 1q.

Here, the main current mirror circuit M is configured of, among the components of the main rectifier 1, the first transistor 1b, the second transistor 1c, the first resistor 1d, the first capacitor 1e, the third transistor 1f, the fourth transistor 1g, the constant current source 1h, the fifth transistor 1i, the sixth transistor 1j, the second resistor 1k, the second capacitor 1m, the seventh transistor 1n, and the eighth transistor 1p, the first resistor circuit 3, and the second resistor circuit 4.

Further, the first main current mirror circuit M1 using n-type metal-oxide-semiconductor field effect transistors (MOSFETs) is configured of the first transistor 1b, the second transistor 1c, the first resistor 1d, the first capacitor 1e, the third transistor 1f, the fourth transistor 1g, and the constant current source 1h of the main rectifier 1 and the first resistor circuit 3. The n-type MOSFET is an example of the n-type transistor.

The reference current (source current) flowing through the first transistor 1b and the second transistor 1c is associated with the first reference current Iref in a fixed relationship by a mirror ratio of the first main current mirror circuit M1. The mirror ratio of the first main current mirror circuit M1 is set to, for example, 1 or a value smaller than 1.

Further, the second main current mirror circuit M2 using p-type metal-oxide-semiconductor field effect transistors (MOSFETs) is configured of the fifth transistor 1i, the sixth transistor 1j, the second resistor 1k, the second capacitor 1m, the seventh transistor 1n, and the eighth transistor 1p of the main rectifier 1 and the second resistor circuit 4. The p-type MOSFET is an example of the p-type transistor.

The reference current (source current) flowing through the fifth transistor 1i and the sixth transistor 1j is associated with the source current flowing through the seventh transistor 1n and the eighth transistor 1p in a fixed relationship by a mirror ratio of the second main current mirror circuit M2. That is, the source current of the seventh transistor 1n and the eighth transistor 1p are set by the reference current flowing through the fifth transistor 1i and the sixth transistor 1j and the mirror ratio of the second main current mirror circuit M2. The mirror ratio of the second main current mirror circuit M2 is set to, for example, a value larger than 1.

In a case where both the mirror ratio of the first main current mirror circuit M1 and the mirror ratio of the second main current mirror circuit M2 are set to 1, the same operation current flows through, in a state where the high-frequency signal RFin is not input to the main rectifier 1, all the transistors, that is, the first transistor 1b, the second transistor 1c, the third transistor 1f, the fourth transistor 1g, the fifth transistor 1i, the sixth transistor 1j, the seventh transistor 1n, the eighth transistor 1p, the ninth transistor 1q, and the tenth transistor 1r.

Next, a detailed configuration of the replica rectifier 2 will be described.

The replica rectifier 2 includes the first transistor 2b, a second transistor 2c, the first resistor 2d, a first capacitor 2e, a third transistor 2f, the fourth transistor 2g, the constant current source 2h, a fifth transistor 2i, a sixth transistor 2j, a second resistor 2k, a second capacitor 2m, a seventh transistor 2n, the eighth transistor 2p, the ninth transistor 2q, and the tenth transistor 2r, as shown in FIG. 4.

That is, as can be seen from a comparison between FIGS. 3 and 4, the replica rectifier 2 has the same circuit configuration and circuit performance as the main rectifier 1, except for the coupling capacitor 1a. Further, element performance (specification such as element value) in each of a plurality of circuit elements of the replica rectifier 2 is the same as element performance in each of a plurality of circuit elements of the main rectifier 1.

Further, the reference current Iref of the replica rectifier 2 is set to be the same as the reference current Iref of the main rectifier 1, and the replica rectifier 2 is placed in the same temperature environment as the main rectifier 1. Accordingly, in a state where the high-frequency signal RFin is not input to the main rectifier 1, the same operation current flows through all the transistors of the replica rectifier 2 and all the transistors of the main rectifier 1.

The first transistor 2b is an n-type transistor. The gate terminal of the first transistor 2b is connected to the drain terminal of the fourth transistor 2g, one end of the first resistor 2d, and the output end of the constant current source 2h, and as shown in FIG. 3, is connected to the drain terminal of the eighth transistor 1p and the drain terminal of the ninth transistor 1q of the main rectifier 1. Further, a drain terminal of the first transistor 2b is connected to a source terminal of the second transistor 2c, and a source terminal of the first transistor 2b is grounded. Such a first transistor 2b is a corresponding transistor in the present invention.

Here, a gate voltage of the first transistor 2b (corresponding transistor) is set based on a second reference current Iref, the first resistor 2d, the first capacitor 2e, the third transistor 2f, the fourth transistor 2g, and the deviation current Idiff input from the main rectifier 1. That is, the gate voltage of the first transistor 2b is set to the reference operation voltage Vb (direct-current voltage) based on the second reference current Iref and the deviation current Idiff.

The reference operation voltage Vb is a voltage higher, by the deviation current Idiff, than the main operation voltage Vm in a state where the high-frequency signal RFin is not input to the main rectifier 1. Therefore, a source current (reference current) flowing in the first transistor 2b is larger, by a copy current of the deviation current Idiff, than a copy current of the second reference current Iref.

The second transistor 2c is an n-type transistor. The second transistor 2c is a cascode transistor that is connected in cascode with the first transistor 2b, as illustrated in the drawing. That is, the source terminal of the second transistor 2c is connected to the drain terminal of the first transistor 2b. Further, a gate terminal of the second transistor 2c is connected to the output end of the first resistor circuit 3, and the first bias voltage V1 is applied to the gate terminal thereof.

Furthermore, a drain terminal of the second transistor 2c is connected to a drain terminal of the fifth transistor 2i, a gate terminal of the sixth transistor 2j, and one end of the second resistor 2k. Such a second transistor 2c is connected in cascode with the first transistor 2b. Accordingly, similarly to the source current of the first transistor 2b, a source current (reference current) flowing in the second transistor 2c is also larger, by the copy current of the deviation current Idiff, than the copy current of the second reference current Iref.

The first resistor 2d has a predetermined resistance value. One end of the first resistor 2d is connected to the gate terminal of the first transistor 2b, the output end of the constant current source 2h, and the drain terminal of the fourth transistor 2g, and as shown in FIG. 3, is connected to the drain terminal of the eighth transistor 1p and the drain terminal of the ninth transistor 1q of the main rectifier 1. The other end of the first resistor 2d is connected to one end of the first capacitor 2e and a gate terminal of the third transistor 2f. The first resistor 2d configures a low-pass filter having a predetermined time constant, together with the first capacitor 2e.

The first capacitor 2e has a predetermined capacitance. One end of the first capacitor 2e is connected to the other end of the first resistor 2d and the gate terminal of the third transistor 2f, and the other end of the first capacitor 2e is grounded. The first capacitor 2e configures a low-pass filter having a predetermined time constant, together with the first resistor 2d.

The third transistor 2f is an n-type transistor. As illustrated in the drawing, the gate terminal of the third transistor 2f is connected to the other end of the first resistor 2d and one end of the first capacitor 2e, a drain terminal of the third transistor 2f is connected to a source terminal of the fourth transistor 2g, and a source terminal of the third transistor 2f is grounded. The third transistor 2f is in diode connection via the fourth transistor 2g. That is, a collector terminal of the third transistor 2f is connected to the gate terminal via the fourth transistor 2g.

The fourth transistor 2g is an n-type transistor. The fourth transistor 2g is a cascode transistor that is connected in cascode with the third transistor 2f. That is, the source terminal of the fourth transistor 2g is connected to the drain terminal of the third transistor 2f. Further, a gate terminal of the fourth transistor 2g is connected to the output end of the first resistor circuit 3, and the first bias voltage V1 is applied to the gate terminal thereof. Furthermore, the drain terminal of the fourth transistor 2g is connected to the output end of the constant current source 2h, the gate terminal of the first transistor 2b, and one end of the first resistor 2d, and as shown in FIG. 3, is connected to the drain terminal of the eighth transistor 1p and the drain terminal of the ninth transistor 1q of the main rectifier 1.

The constant current source 2h is connected to the gate terminal of the first transistor 2b, one end of the first resistor 2d, and the drain terminal of the fourth transistor 2g, and as shown in FIG. 3, is connected to the drain terminal of the eighth transistor 1p and the drain terminal of the ninth transistor 1q of the main rectifier 1. The second reference current Iref (direct current) is output from the output end of the constant current source 2h.

The fifth transistor 2i is a p-type transistor. The fifth transistor 2i is a cascode transistor that is connected in cascode with the sixth transistor 2j, as illustrated in the drawing. That is, a source terminal of the fifth transistor 2i is connected to a drain terminal of the sixth transistor 2j. Further, a gate terminal of the fifth transistor 2i is connected to the output end of the second resistor circuit 4, and the second bias voltage V2 is applied to the gate terminal thereof. Furthermore, the drain terminal of the fifth transistor 2i is connected to the drain terminal of the second transistor 2c, the gate terminal of the sixth transistor 2j, and one end of the second resistor 2k.

The sixth transistor 2j is a p-type transistor. As illustrated in the drawing, a gate terminal of the sixth transistor 2j is connected to the drain terminal of the second transistor 2c, the drain terminal of the fifth transistor 2i, and one end of the second resistor 2k, the drain terminal of the sixth transistor 2j is connected to the source terminal of the fifth transistor 2i, and a source terminal of the sixth transistor 2j is connected to the power supply Vcc, the other end of the second capacitor 2m, and the source terminal of the seventh transistor 2n.

A source current (reference current) based on the reference operation voltage Vb flows through the fifth transistor 2i and the sixth transistor 2j having a relationship of cascode connection, similarly to the first transistor 2b and the second transistor 2c having a relationship of cascode connection.

One end of the second resistor 2k is connected to the drain terminal of the second transistor 2c, the drain terminal of the fifth transistor 2i, and the gate terminal of the sixth transistor 2j, and the other end of the second resistor 2k is connected to one end of the second capacitor 2m and a gate terminal of the seventh transistor 2n. The second resistor 2k configures a low-pass filter having a predetermined time constant, together with the second capacitor 2m.

The second capacitor 2m has a predetermined capacitance. One end of the second capacitor 2m is connected to the other end of the second resistor 2k and the gate terminal of the seventh transistor 2n, and the other end of the second capacitor 2m is connected to the power supply Vcc, the source terminal of the sixth transistor 2j, and a source terminal of the seventh transistor 2n. The second capacitor 2m configures a low-pass filter having a predetermined time constant, together with the second resistor 2k.

The seventh transistor 2n is a p-type transistor. As illustrated in the drawing, the gate terminal of the seventh transistor 2n is connected to the other end of the second resistor 2k and one end of the second capacitor 2m, a drain terminal of the seventh transistor 2n is connected to a source terminal of the eighth transistor 2p, and the source terminal of the seventh transistor 2n is connected to the power supply Vcc, the source terminal of the sixth transistor 2j, and the other end of the second capacitor 2m. The same source current as the reference current flows through the seventh transistor 2n, similarly to the fifth transistor 2i and the sixth transistor 2j.

The eighth transistor 2p is a p-type transistor. The eighth transistor 2p is a cascode transistor that is connected in cascode with the seventh transistor 2n, as illustrated in the drawing. That is, the source terminal of the eighth transistor 2p is connected to the drain terminal of the seventh transistor 2n. Further, a gate terminal of the eighth transistor 2p is connected to the output end of the second resistor circuit 4, and the second bias voltage V2 is applied to the gate terminal thereof.

Furthermore, the drain terminal of the eighth transistor 2p is connected to the drain terminal of the ninth transistor 2q and the gate terminal of the tenth transistor 2r, and is connected to the gate terminal of the tenth transistor 1r of the main rectifier 1. That is, the drain terminal of the eighth transistor 2p is an output end that outputs the reference voltage Vr to the main rectifier 1.

The reference voltage Vr is a direct-current voltage set by a source current of the eighth transistor 2p and the tenth transistor 2r of the replica rectifier 2 and the tenth transistor 1r of the main rectifier 1. That is, the reference voltage Vr is a direct-current voltage indicating the reference current of the replica rectifier 2.

The ninth transistor 2q is an n-type transistor. The ninth transistor 2q is a cascode transistor that is connected in cascode with the tenth transistor 2r, as illustrated in the drawing. That is, a source terminal of the ninth transistor 2q is connected to a drain terminal of the tenth transistor 2r. Further, a gate terminal of the ninth transistor 2q is connected to the output end of the first resistor circuit 3, and the first bias voltage V1 is applied to the gate terminal thereof. Furthermore, the drain terminal of the ninth transistor 2q is connected to the drain terminal of the eighth transistor 2p.

The tenth transistor 2r is an n-type transistor. As illustrated in the drawing, the gate terminal of the tenth transistor 2r is connected to the drain terminal of the eighth transistor 2p and the drain terminal of the ninth transistor 2q, and is connected to the gate terminal of the tenth transistor 1r of the main rectifier 1. Further, the drain terminal of the tenth transistor 2r is connected to the source terminal of the ninth transistor 2q, and a source terminal of the tenth transistor 2r is grounded.

Here, the reference current mirror circuit R is configured of, among the components of the replica rectifier 2, the first transistor 2b, the second transistor 2c, the first resistor 2d, the first capacitor 2e, the third transistor 2f, the fourth transistor 2g, the constant current source 2h, the fifth transistor 2i, the sixth transistor 2j, the second resistor 2k, the second capacitor 2m, the seventh transistor 2n, and the eighth transistor 2p, the first resistor circuit 3, and the second resistor circuit 4.

Further, the first reference current mirror circuit R1 using the n-type MOSFETs is configured of the first transistor 2b, the second transistor 2c, the first resistor 2d, the first capacitor 2e, the third transistor 2f, the fourth transistor 2g, and the constant current source 2h of the replica rectifier 2 and the first resistor circuit 3.

A reference current (source current) flowing through the first transistor 2b and the second transistor 2c is associated with the source current flowing through the third transistor 2f and the fourth transistor 2g in a fixed relationship by a mirror ratio of the first reference current mirror circuit R1. That is, the source current of the third transistor 2f and the fourth transistor 2g is set based on the reference current of the first transistor 2b and the second transistor 2c and the mirror ratio of the first reference current mirror circuit R1. The mirror ratio of the first reference current mirror circuit R1 is set to, for example, 1 or a value smaller than 1.

Further, the fifth transistor 2i, the sixth transistor 2j, the second resistor 2k, the second capacitor 2m, the seventh transistor 2n, the eighth transistor 2p, and the second resistor circuit 4 similarly configure, as can be seen from a connection state, the second reference current mirror circuit R2 using the p-type MOSFETs.

A source current flowing through the fifth transistor 2i and the sixth transistor 2j is associated with the source current flowing through the seventh transistor 2n and the eighth transistor 2p in a fixed relationship by a mirror ratio of the second reference current mirror circuit R2. That is, the source current of the seventh transistor 2n and the eighth transistor 2p is set based on the source current of the fifth transistor 2i and the sixth transistor 2j and the mirror ratio of the second reference current mirror circuit R2. The mirror ratio of the second reference current mirror circuit R2 is set to, for example, a value larger than 1.

In a case where both the mirror ratio of the first reference current mirror circuit R1 and the mirror ratio of the second reference current mirror circuit R2 are set to 1, the same operation current flows through, in the state where the high-frequency signal RFin is not input to the main rectifier 1, all the transistors of the replica rectifier 2, that is, the first transistor 2b, the second transistor 2c, the third transistor 2f, the fourth transistor 2g, the fifth transistor 2i, the sixth transistor 2j, the seventh transistor 2n, the eighth transistor 2p, the ninth transistor 2q, and the tenth transistor 2r.

Further, the drain terminal of the tenth transistor 2r in the replica rectifier 2 is connected to the gate terminal of the tenth transistor 2r via the ninth transistor 2q. Therefore, the current mirror circuit for connection C using the n-type MOSFETs is configured of the ninth transistor 1q and the tenth transistor 1r of the main rectifier 1, the ninth transistor 2q and the tenth transistor 2r of the replica rectifier 2, and the first resistor circuit 3.

The input end of the current mirror circuit for connection C (drain terminal of the ninth transistor 2q in the replica rectifier 2) is connected to the output end of the second reference current mirror circuit R2 (drain terminal of the eighth transistor 2p in the replica rectifier 2), and the output end of the current mirror circuit for connection C (drain terminal of the ninth transistor 1q in the main rectifier 1) is connected to the output end of the second main current mirror circuit M2 (drain terminal of the eighth transistor 1p in the main rectifier 1).

That is, a main portion (the first main current mirror circuit M1 and the second main current mirror circuit M2) of the main rectifier 1 and a main portion (the first reference current mirror circuit R1 and the second reference current mirror circuit R2) of the replica rectifier 2 are connected to each other by the current mirror circuit for connection C to configure a closed loop. The closed loop is a negative feedback loop that performs negative feedback to the main rectifier 1 and the replica rectifier 2 using a current as a medium.

A mirror ratio of such a current mirror circuit for connection C is set to, for example, 1. That is, the current mirror circuit for connection C sets a source current of the ninth transistor 1q and the tenth transistor 1r to a current identical to the reference current, that is, the reference current, based on the reference current flowing in from the output end of the second reference current mirror circuit R2.

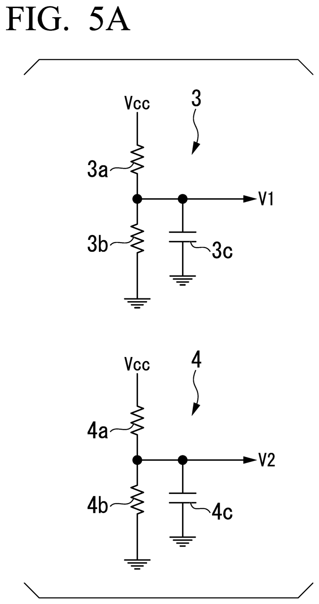

The first resistor circuit 3 includes a first resistor 3a, a second resistor 3b, and a capacitor 3c as shown in FIG. 5A, and outputs the first bias voltage V1. The first resistor 3a has a predetermined resistance value. One end of the first resistor 3a is connected to the power supply Vcc, and the other end of the first resistor 3a is connected to one end of the second resistor 3b and one end of the capacitor 3c.

The second resistor 3b has a predetermined resistance value. One end of the second resistor 3b is connected to the other end of the first resistor 3a and one end of the capacitor 3c, and the other end of the second resistor 3b is grounded. That is, the second resistor 3b is connected in series with the first resistor 3a, and configures a first resistor voltage-dividing circuit together with the first resistor 3a. The first resistor voltage-dividing circuit outputs the first bias voltage V1 obtained by dividing a direct-current voltage of the power supply Vcc (power supply voltage) by a resistance value of the first resistor 3a and a resistance value of the second resistor 3b.

One end of the capacitor 3c is connected to the other end of the first resistor 3a and one end of the second resistor 3b, and the other end of the capacitor 3c is grounded. The capacitor 3c configures a low-pass filter together with the first resistor 3a and the second resistor 3b, and prevents external noise from being superimposed on the first bias voltage V1.

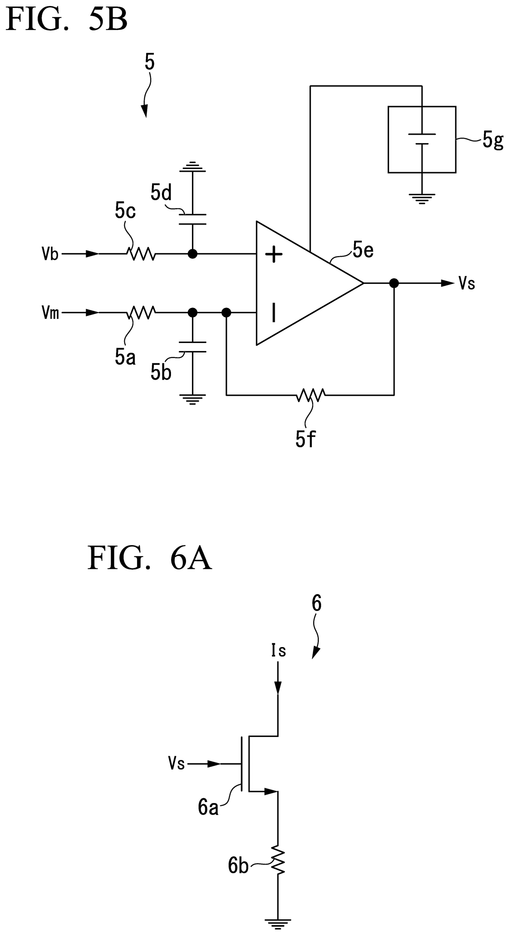

The second resistor circuit 4 similarly includes a first resistor 4a, a second resistor 4b, and a capacitor 4c as shown in FIG. 5B, and outputs the second bias voltage V2. The first resistor 4a has a predetermined resistance value. One end of the first resistor 4a is connected to the power supply Vcc, and the other end of the first resistor 4a is connected to one end of the second resistor 4b and one end of the capacitor 4c.

The second resistor 4b has a predetermined resistance value. One end of the second resistor 4b is connected to the other end of the first resistor 4a and one end of the capacitor 4c, and the other end of the second resistor 4b is grounded. That is, the second resistor 4b is connected in series with the first resistor 4a, and configures a second resistor voltage-dividing circuit together with the first resistor 4a. The second resistor voltage-dividing circuit outputs the second bias voltage V2 obtained by dividing the direct-current voltage of the power supply Vcc (power supply voltage) by a resistance value of the first resistor 4a and a resistance value of the second resistor 4b.

One end of the capacitor 4c is connected to the other end of the first resistor 4a and one end of the second resistor 4b, and the other end of the capacitor 4c is grounded. The capacitor 4c configures a low-pass filter together with the first resistor 4a and the second resistor 4b, and prevents the external noise from being superimposed on the second bias voltage V2.

The differential amplifier 5 includes a first resistor 5a, a first capacitor 5b, a second resistor 5c, a second capacitor 5d, an operational amplifier 5e, a feedback resistor 5f, and a voltage source 5g as shown in FIG. 5B, and differentially amplifies the main operation voltage Vm of the main rectifier 1 and the reference operation voltage Vb of the replica rectifier 2 to generate the difference voltage Vs. The difference voltage Vs is a power detection signal in the present invention.

The first resistor 5a has a predetermined resistance value. One end of the first resistor 5a is one input end in the differential amplifier 5, and is connected to the main rectifier 1 to receive the main operation voltage Vm. That is, one end of the first resistor 5a is connected to the other end of the coupling capacitor 1a, the gate terminal of the first transistor 1b, one end of the first resistor 1d, the drain terminal of the fourth transistor 1g, and the output end of the constant current source 1h in the main rectifier 1. Further, the other end of the first resistor 5a is connected to one end of the first capacitor 5b, an inverting input terminal of the operational amplifier 5e, and one end of the feedback resistor 5f. Such a first resistor 5a configures a low-pass filter together with the first capacitor 5b.

The first capacitor 5b has a predetermined capacitance. One end of the first capacitor 5b is connected to the other end of the first resistor 5a, the inverting input terminal of the operational amplifier 5e, and one end of the feedback resistor 5f, and the other end of the first capacitor 5b is grounded. The first capacitor 5b configures a low-pass filter together with the first resistor 5a, and removes an alternating-current component superimposed on the main operation voltage Vm to input only the direct-current component of the main operation voltage Vm to the inverting input terminal of the operational amplifier 5e.

The second resistor 5c has a predetermined resistance value. One end of the second resistor 5c is the other input end in the differential amplifier 5, and is connected to the replica rectifier 2 to receive the reference operation voltage Vb. That is, one end of the second resistor 5c is connected to the gate terminal of the first transistor 2b, one end of the first resistor 2d, a collector terminal of the fourth transistor 2g, and the constant current source 2h in the replica rectifier 2, and is connected to the drain terminal of the eighth transistor 1p and the drain terminal of the ninth transistor 1q in the main rectifier 1. Further, the other end of the second resistor 5c is connected to one end of the second capacitor 5d and a non-inverting input terminal of the operational amplifier 5e. Such a second resistor 5c configures a low-pass filter together with the second capacitor 5d.

The second capacitor 5d has a predetermined capacitance. One end of the second capacitor 5d is connected to the other end of the second resistor 5c and the non-inverting input terminal of the operational amplifier 5e, and the other end of the second capacitor 5d is grounded. The second capacitor 5d configures a low-pass filter together with the second resistor 5c, and removes an alternating-current component that may be superimposed on the reference operation voltage Vb to input only a direct-current component of the reference operation voltage Vb to the non-inverting input terminal of the operational amplifier 5e.

The operational amplifier 5e is an integrated circuit including the inverting input terminal, the non-inverting input terminal, an output terminal, and an offset terminal. The inverting input terminal of the operational amplifier 5e is connected to the other end of the first resistor 5a, one end of the first capacitor 5b, and one end of the feedback resistor 5f, as illustrated in the drawing. The non-inverting input terminal of the operational amplifier 5e is connected to the other end of the second resistor 5c and one end of the second capacitor 5d.

Further, the output terminal of the operational amplifier 5e is connected to the other end of the feedback resistor 5f, and is connected to an input end of the voltage-to-current conversion circuit 6. Furthermore, the offset terminal of the operational amplifier 5e is connected to an output end of the voltage source 5g. In such an operational amplifier 5e, an offset voltage between the inverting input terminal and the non-inverting input terminal is corrected by a voltage for offset correction (direct-current voltage) applied to the offset terminal.

The feedback resistor 5f has a predetermined resistance value. One end of the feedback resistor 5f is connected to the inverting input terminal of the operational amplifier 5e, the other end of the first resistor 5a, and one end of the first capacitor 5b, and the other end of the feedback resistor 5f is connected to the output terminal of the operational amplifier 5e and the input end of the voltage-to-current conversion circuit 6. The feedback resistor 5f sets an amplification degree of the differential amplifier 5 together with the first resistor 5a. That is, the amplification degree of the differential amplifier 5 is set based on a ratio between the resistance value of the first resistor 5a and the resistance value of the feedback resistor 5f.

The output end of the voltage source 5g is connected to the offset terminal of the operational amplifier 5e. This offset terminal is used to boost (offset) the output voltage Vs of the differential amplifier 5. The voltage source 5g generates a predetermined voltage for offset correction (direct-current voltage), and outputs the generated voltage to the offset terminal of the operational amplifier 5e.

Since the output voltage (difference voltage Vs) of the differential amplifier 5 approaches zero in a case where the high-frequency signal RFin is small, the output voltage thereof cannot exceed a threshold voltage of the subsequent voltage-to-current conversion circuit 6 unless the high-frequency signal RFin is increased to some extent. That is, the differential amplifier 5 cannot output the current to the voltage-to-current conversion circuit 6 unless the high-frequency signal RFin is increased to some extent. In the differential amplifier 5 in the present embodiment, the voltage for offset correction is applied from the voltage source 5g to the offset terminal of the differential amplifier 5 to improve the sensitivity to the high-frequency signal RFin.

The difference voltage Vs output from the differential amplifier 5 to the voltage-to-current conversion circuit 6 is a direct-current voltage indicating a difference between the main operation voltage Vm of the main rectifier 1 and the reference operation voltage Vb of the replica rectifier 2, and is the detection voltage indicating the power of the high-frequency signal RFin. Further, the main rectifier 1 and the replica rectifier 2 are configured by the same circuit configuration and the same circuit element, and are placed in the same temperature environment. Accordingly, the difference voltage Vs is a detection voltage in which the influence of a manufacturing variation of the first transistor 1b in the main rectifier 1 or a temperature fluctuation is suppressed.

The voltage-to-current conversion circuit 6 includes a transistor 6a and a resistor 6b, and converts the difference voltage Vs input from the differential amplifier 5 into the difference current Is, as shown in FIG. 6A. The transistor 6a is an n-type MOSFET, as illustrated in the drawing. A gate terminal of the transistor 6a is connected to an output end of the differential amplifier 5 (output terminal of operational amplifier 5e), a drain terminal of the transistor 6a is connected to the input end of the output circuit W, and a source terminal of the transistor 6a is connected to one end of the resistor 6b.

The resistor 6b has a predetermined resistance value. One end of the resistor 6b is connected to a source terminal of the transistor 6a, and the other end of the resistor 6b is grounded. In such a voltage-to-current conversion circuit 6, the difference current Is is set based on the difference voltage Vs applied to a gate terminal of the transistor 6a and the resistance value of the resistor 6b.

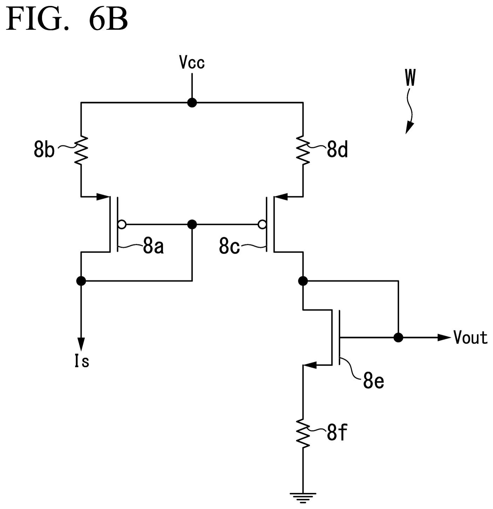

The output circuit W includes a first transistor 8a, a first resistor 8b, a second transistor 8c, a second resistor 8d, a third transistor 8e, and a third resistor 8f, as shown in FIG. 6B. The output circuit W is a current-to-voltage conversion circuit that is configured to convert the difference current Is into the output voltage Vout of the power detector A.

The first transistor 8a and the second transistor 8c in the output circuit W are p-type MOSFETs, as illustrated in the drawing. Further, the third transistor 8e in the output circuit W is an n-type MOSFET. Further, as can be seen from a connection state, the first transistor 8a, the first resistor 8b, the second transistor 8c, the second resistor 8d, and the third transistor 8e configure a current mirror circuit.

A gate terminal of the first transistor 8a is connected to a drain terminal of the first transistor 8a and a gate terminal of the second transistor 8c, and the drain terminal of the first transistor 8a is connected to the gate terminal of the first transistor 8a, the gate terminal of the second transistor 8c, and a drain terminal of the transistor 6a. Further, a source terminal of the first transistor 8a is connected to one end of the first resistor 8b. That is, the gate terminal and the drain terminal of the first transistor 8a are in diode connection.

The first resistor 8b has a predetermined resistance value. One end of the first resistor 8b is connected to the source terminal of the first transistor 8a, and the other end of the first resistor 8b is connected to the power supply Vcc and the other end of the second resistor 8d. The first resistor 8b sets a mirror ratio of the current mirror circuit together with the second resistor 8d.

The gate terminal of the second transistor 8c is connected to the gate terminal and the drain terminal of the first transistor 8a, and is connected to the drain terminal of the transistor 6a. A drain terminal of the second transistor 8c is connected to a drain terminal and a gate terminal of the third transistor 8e, and is connected to a subsequent stage circuit (not illustrated). Further, a source terminal of the second transistor 8c is connected to one end of the second resistor 8d.

The drain terminal of the second transistor 8c is an output end of the output circuit W, and outputs the output voltage Vout to the subsequent stage circuit. The output voltage Vout is a direct-current voltage set by a source current of the second transistor 8c and by the third transistor 8e and the third resistor 8f which are loads of the second transistor 8c, and is the detection voltage indicating the power of the high-frequency signal RFin.

One end of the second resistor 8d is connected to the source terminal of the second transistor 8c, and the other end of the second resistor 8d is connected to the power supply Vcc and the other end of the first resistor 8b. The second resistor 8d sets the mirror ratio of the current mirror circuit together with the first resistor 8b. That is, the source current of the second transistor 8c is obtained by multiplying the difference current Is by the mirror ratio.

The gate terminal of the third transistor 8e is connected to the drain terminal of the third transistor 8e and the subsequent stage circuit, the drain terminal of the third transistor 8e is connected to a gate terminal of the third transistor 8e and the subsequent stage circuit, and a source terminal of the third transistor 8e is connected to one end of the third resistor 8f. The third transistor 8e configures the load of the second transistor 8c together with the third resistor 8f, and generates the output voltage Vout based on the source current of the second transistor 8c.

The third resistor 8f has a predetermined resistance value. One end of the third resistor 8f is connected to the source terminal of the third transistor 8e, and the other end of the third resistor 8f is grounded. The third resistor 8f configures the load of the second transistor 8c together with the third transistor 8e, and generates the output voltage Vout based on the source current of the second transistor 8c and the resistance value of the third resistor 8f.

The power detector A according to the present embodiment includes, as a whole, n pieces of the first main current mirror circuit M1, the second main current mirror circuit M2, the first reference current mirror circuit R1, the second reference current mirror circuit R2, the current mirror circuit for connection C, the differential amplifier 5, and the voltage-to-current conversion circuit 6, and the single output circuit W.

Next, the operation and performance of the power detector A according to the present embodiment will be described in detail.

First, in the first main current mirror circuit M1 of the main rectifier 1, the gate bias voltage of the first transistor 1b (initial-stage transistor) is set based on the first reference current Iref output from the constant current source 1h. The first transistor 1b performs the half-wave rectification on the high-frequency signal RFin input from the outside with the gate bias voltage as the threshold value. That is, in the main rectifier 1, the high-frequency signal RFin is subjected to the half-wave rectification in the first main current mirror circuit M1.

In the main rectifier 1, the output end of the first main current mirror circuit M1 is connected to the input end of the second main current mirror circuit M2. Accordingly, the half-wave rectified signal generated by the first main current mirror circuit M1 is input to the second main current mirror circuit M2 and is smoothed to be the detection voltage (direct-current voltage) indicating the power of the high-frequency signal RFin. The detection voltage is input to the gate terminal of the seventh transistor 1n of the second main current mirror circuit M2 to be converted into the detection current, that is, the source current of the seventh transistor 1n and the eighth transistor 1p.

On the other hand, in the main rectifier 1, the output end of the second main current mirror circuit M2 is connected to the output end of the current mirror circuit for connection C. Therefore, the source current of the ninth transistor 1q and the tenth transistor 1r configuring the current mirror circuit for connection C is set to the reference current based on the reference voltage Vr input to the gate terminal of the tenth transistor 1r from the replica rectifier 2.

Therefore, in the main rectifier 1, the deviation current Idiff, which is the difference between the detection current and the reference current, is output to the replica rectifier 2 from the output end of the second main current mirror circuit M2, that is, the output end of the current mirror circuit for connection C. Such a deviation current Idiff is a current signal that indicates the power of the high-frequency signal RFin and indicates an operation state of the replica rectifier 2 to which the high-frequency signal RFin is not input.

Subsequently, in the first reference current mirror circuit R1 of the replica rectifier 2, the gate bias voltage of the first transistor 2b (corresponding transistor) is set based on the total current of the deviation current Idiff and the second reference current Iref. The source current of the first transistor 2b and the second transistor 2c is set to an amount obtained by multiplying the total current by the mirror ratio of the first reference current mirror circuit R1.

In the replica rectifier 2, since the output end of the first reference current mirror circuit R1 is connected to the input end of the second reference current mirror circuit R2, a reference current of the second reference current mirror circuit R2 is an output current of the first reference current mirror circuit R1, that is, the source current of the first transistor 2b and the second transistor 2c. That is, the second reference current mirror circuit R2 sets the source current (reference current) of the seventh transistor 2n and the eighth transistor 2p to an amount obtained by multiplying the reference current by the mirror ratio of the second reference current mirror circuit R2.

Since the output end of the second reference current mirror circuit R2 is connected to the input end of the current mirror circuit for connection C, the reference current is a reference current of the current mirror circuit for connection C. That is, the current mirror circuit for connection C sets the source current of the ninth transistor 1q and the tenth transistor 1r of the main rectifier 1 to an amount obtained by multiplying the reference current by the mirror ratio of the current mirror circuit for connection C.

That is, the main rectifier 1 and the replica rectifier 2 in the power detector A according to the present embodiment are in a mutual feedback (negative feedback) relationship. In a reference state in which the high-frequency signal RFin is not input to the main rectifier 1, the deviation current Idiff generated by the main rectifier 1 is zero.

That is, in the reference state in which the high-frequency signal RFin is not input to the main rectifier 1, the gate voltage of the first transistor 1b (initial-stage transistor) of the main rectifier 1, that is, the main operation voltage Vm is equal to the gate voltage of the first transistor 2b (corresponding transistor) of the replica rectifier 2, that is, the reference operation voltage Vb.

On the other hand, in the operation state in which the high-frequency signal RFin is input to the main rectifier 1, the deviation current Idiff is increased from zero in accordance with the power (amplitude) of the high-frequency signal RFin. As a result, the reference operation voltage Vb of the replica rectifier 2 is also increased. Therefore, the main operation voltage Vm and the reference operation voltage Vb have a deviation in accordance with the power of the high-frequency signal RFin.

Such a main operation voltage Vm and a reference operation voltage Vb are subjected to the differential amplification by the differential amplifier 5 to be converted into the difference voltage Vs. The difference voltage Vs is a voltage signal based on the difference between the main operation voltage Vm and the reference operation voltage Vb, which are generated by the main rectifier 1 and the replica rectifier 2 having the same circuit configuration and circuit performance.

That is, the difference voltage Vs corrects the manufacturing variation of the first transistor 1b (initial-stage transistor) of the main rectifier 1 with a manufacturing variation of the first transistor 2b (corresponding transistor) of the replica rectifier 2 having the same configuration as the first transistor 1b, and corrects an operational variation of the first transistor 1b due to the temperature fluctuation with an operational variation of the first transistor 2b of the replica rectifier 2 having the same configuration as the first transistor 1b due to the temperature fluctuation, in addition to indicating the power of the high-frequency signal RFin.

Such a difference voltage Vs is converted into the difference current Is by the voltage-to-current conversion circuit 6, and the difference current Is is input to the output circuit W. Since the difference current Is is input to the output circuit W from each of the n power detection units U1 to Un, averaging processing is performed on the n difference currents Is at the input end of the output circuit W. That is, a detection error that may be included in the n difference currents Is is reduced by the averaging processing.

The difference current Is after the averaging processing is converted into the output voltage Vout in the output circuit W. The output voltage Vout is an output signal of the power detector A according to the present embodiment, and is a signal indicating the power of the high-frequency signal RFin in which the influence of the manufacturing variation of the first transistor 1b (initial-stage transistor) of the main rectifier 1 or the temperature fluctuation is corrected.

In such a power detector A, the first main current mirror circuit M1 and the second main current mirror circuit M2, which are main portions of the main rectifier 1, and the first reference current mirror circuit R1 and the second reference current mirror circuit R2, which are main portions of the replica rectifier 2, are connected to each other by the current mirror circuit for connection C to configure the negative feedback loop (current negative feedback loop) using a current as a medium. Therefore, according to the present embodiment, it is possible to suppress the influence of the external noise, as compared with a case where the negative feedback loop (voltage negative feedback loop) is configured using a voltage as a medium as in the background art.

Further, according to the present embodiment, the negative feedback loop is configured by the interconnection of the first main current mirror circuit M1 configured of the n-type transistors, the second main current mirror circuit M2 configured of the p-type transistors, the first reference current mirror circuit R1 configured of the n-type transistors, the second reference current mirror circuit R2 configured of the p-type transistors, and the current mirror circuit for connection C configured of the n-type transistors. Therefore, it is possible to reduce the number of components.

Further, in the power detector A according to the present embodiment, the mirror ratios of the second main current mirror circuit M2 and the second reference current mirror circuit R2 are set to the values larger than 1, and the mirror ratios of the first main current mirror circuit M1 and the first reference current mirror circuit R1 are set to 1 or the values smaller than 1.

That is, the mirror ratios of the second main current mirror circuit M2 and the second reference current mirror circuit R2 are set to be larger than the mirror ratios of the first main current mirror circuit M1 and the first reference current mirror circuit R1. According to the present embodiment, it is possible to improve the sensitivity in detecting the power of the high-frequency signal RFin, as compared with a case where the mirror ratios of the second main current mirror circuit M2 and the second reference current mirror circuit R2 are set to be smaller than the mirror ratios of the first main current mirror circuit M1 and the first reference current mirror circuit R1.

Further, according to the present embodiment, the n power detection units U1 to Un are provided, and the detection currents Is of the respective power detection units U1 to Un are subjected to the averaging processing. Therefore, it is possible to improve the detection accuracy of the power of the high-frequency signal RFin, as compared with a case where a single power detection unit is provided.

### (Second Embodiment)

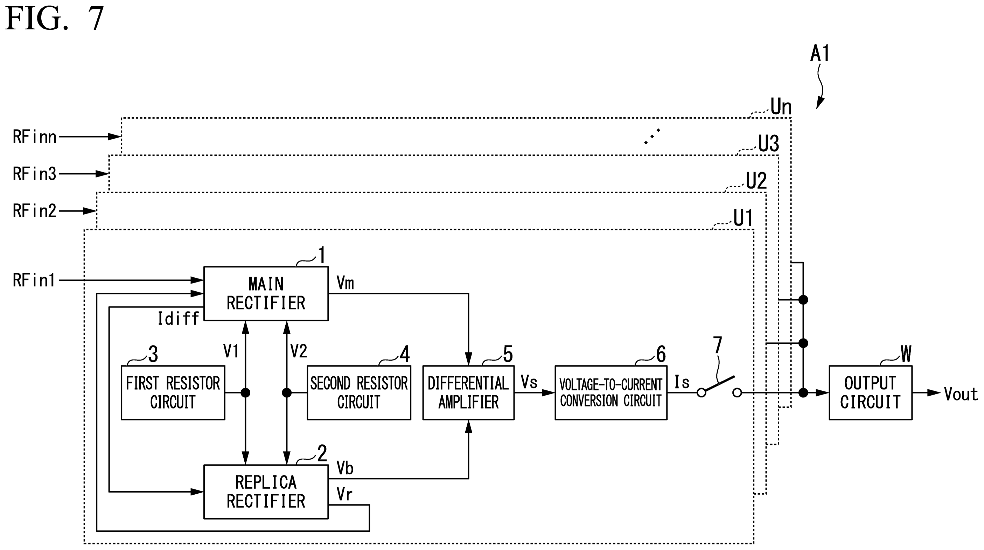

Hereinafter, a second embodiment of the present invention will be described with reference to FIG. 7. In the following description, the same reference numerals are assigned to the configurations common to the first embodiment, and a duplicate description will be omitted. In the following description, differences from the first embodiment will be mainly described.

FIG. 7 is a circuit diagram showing an overall configuration of a power detector A1 according to the second embodiment of the present invention. The power detector A1 according to the second embodiment is different from the power detector A according to the first embodiment in that each of the n power detection units U1 to Un further includes an opening/closing switch 7. One contact of the opening/closing switch 7 is connected to the output end of the voltage-to-current conversion circuit 6, and the other contact of the opening/closing switch 7 is connected to the input end of the output circuit W. Specifically, the drain terminal of the transistor 6a of the voltage-to-current conversion circuit 6 is connected to the one contact of the opening/closing switch 7, and the drain terminal and the gate terminal of the first transistor 8a provided in the output circuit W are connected to the other contact of the opening/closing switch 7. The opening/closing switch 7 is set to a closed state selectively for the n power detection units U1 to Un. That is, any one of the n difference currents Is, which are generated by the n power detection units U1 to Un, is input to the output circuit W.

The power detector A1 according to the present embodiment includes, as a whole, n pieces of the first main current mirror circuit M1, the second main current mirror circuit M2, the first reference current mirror circuit R1, the second reference current mirror circuit R2, the current mirror circuit for connection C, the differential amplifier 5, the voltage-to-current conversion circuit 6, and the opening/closing switch 7, and the single output circuit W.

With the power detector A1 according to the present embodiment, the power detection signal of each of the plurality of power detection units is sequentially switched by the opening/closing switch, and is transmitted to the output circuit. Therefore, it is possible to detect the power of the high-frequency signal, which is input to and output from each of the plurality of power detection units.

The present invention is not limited to the first and second embodiments. For example, it is possible to consider the following modification examples.
(1) In the first and second embodiments, the metal-oxide-semiconductor field effect transistor (MOSFET) is used as the transistor configuring each current mirror circuit. However, the present invention is not limited thereto. For example, a transistor in a form other than the MOSFET, such as a junction-type transistor, may be employed.
(2) In the first and second embodiments, the mirror ratios of the second main current mirror circuit M2 and the second reference current mirror circuit R2 are set to the values larger than 1, and the mirror ratios of the first main current mirror circuit M1 and the first reference current mirror circuit R1 are set to 1 or the values smaller than 1. However, the present invention is not limited thereto. Further, the mirror ratio of the current mirror circuit for connection C is not limited to 1.
(3) In the first and second embodiments, the n power detection units U1 to Un are provided. However, the present invention is not limited thereto. For example, in a case where the averaging processing of the detection power is not necessary, only one power detection unit may be provided.

### REFERENCE SIGNS LIST

A, A1 Power detector
C Current mirror circuit for connection
M Main current mirror circuit
M1 First main current mirror circuit
M2 Second main current mirror circuit
R Reference current mirror circuit
R1 First reference current mirror circuit
R2 Second reference current mirror circuit
U1 to Un Power detection unit
W Output circuit
1 Main rectifier
2 Replica rectifier
3 First resistor circuit
4 Second resistor circuit
5 Differential amplifier
6 Voltage-to-current conversion circuit
7 Opening/closing switch

## Claims

1. A power detector comprising:
a main current mirror circuit that is configured to rectify a high-frequency signal to output, from a main output end, a detection current indicating power of the high-frequency signal;
a reference current mirror circuit that has the same circuit configuration and circuit performance as the main current mirror circuit;
a current mirror circuit for connection that has an input end connected to a reference output end of the reference current mirror circuit and has a connection output end connected to the main output end to output a reference current; and
a differential amplifier that is configured to differentially amplify an input voltage of an initial-stage transistor, to which the high-frequency signal is input, in the main current mirror circuit and an input bias voltage of a corresponding transistor, which corresponds to the initial-stage transistor, in the reference current mirror circuit to generate a power detection signal,
wherein the input bias voltage of the initial-stage transistor in the main current mirror circuit is set based on a first reference current,
the input bias voltage of the corresponding transistor in the reference current mirror circuit is set based on a total current of a deviation current between the detection current and the reference current and a second reference current, and
the first reference current and the second reference current are the same.

2. The power detector according to Claim 1,
wherein the main current mirror circuit includes
a first main current mirror circuit that is configured of n-type transistors and includes the initial-stage transistor, and
a second main current mirror circuit that is connected to an output end of the first main current mirror circuit and is configured of p-type transistors, and
the reference current mirror circuit includes
a first reference current mirror circuit that is configured of n-type transistors and includes the corresponding transistor, and
a second reference current mirror circuit that is connected to an output end of the first reference current mirror circuit and is configured of p-type transistors.

3. The power detector according to Claim 2,
wherein mirror ratios of the second main current mirror circuit and the second reference current mirror circuit are set to values larger than 1.

4. The power detector according to Claim 2 or 3,
wherein mirror ratios of the first main current mirror circuit and the first reference current mirror circuit are set to 1 or values smaller than 1.

5. The power detector according to any one of Claims 2 to 4,
wherein the n-type transistor is an n-type metal-oxide-semiconductor field effect transistor (MOSFET), and
the p-type transistor is a p-type metal-oxide-semiconductor field effect transistor (MOSFET).

6. The power detector according to any one of Claims 1 to 5,
wherein the differential amplifier is an instrumentation amplifier.

7. The power detector according to any one of Claims 1 to 6, further comprising:
a voltage-to-current conversion circuit that is configured to convert an output voltage of the differential amplifier into a current; and
a current-to-voltage conversion circuit that is configured to convert an output current of the voltage-to-current conversion circuit into a voltage.

8. The power detector according to any one of Claims 1 to 7, further comprising:
a plurality of power detection units each of which includes
a main circuit configured of a main rectifier, a first resistor circuit, and a second resistor circuit,
a reference circuit configured of a replica rectifier, the first resistor circuit, and the second resistor circuit, and
the differential amplifier,
wherein the power detection signals of the plurality of power detection units are averaged to detect the power of the high-frequency signal.

9. The power detector according to any one of Claims 1 to 7, further comprising:
a plurality of power detection units each of which includes
a main circuit configured of a main rectifier, a first resistor circuit, and a second resistor circuit,
a reference circuit configured of a replica rectifier, the first resistor circuit, and the second resistor circuit,
the differential amplifier, and
an opening/closing switch,
wherein each of the power detection signals of the plurality of power detection units is sequentially switched by the opening/closing switch and is transmitted to an output circuit to detect the power of the high-frequency signal input to and output from each of the plurality of power detection units.
